# EUROPEAN PATENT APPLICATION

(11) **EP 4 345 824 A1**
(43) Date of publication of application: **03.04.2024**
(21) Application number: 21962185.1
(22) Date of filing: 08.12.2021
(51) Int. Cl.: G11C 16/04, G11C 16/16

(54) **FLASH MEMORY, FLASH MEMORY ERASE/WRITE COUNTING METHOD, ELECTRONIC DEVICE, AND COMPUTER STORAGE MEDIUM**

(30) Priority: 29.10.2021 CN 202111276797
(71) Applicant: Rolling Wireless S.À R.L., 2540 Luxembourg (LU)
(72) Inventor: LIU, Jian, Shenzhen, Guangdong 518055 (CN)
(74) Representative: J A Kemp LLP
(86) International application number: PCT/CN2021/136387
(87) International publication number: WO 2023/070842

(57) **Abstract**

The disclosed are a flash memory, a flash memory program/erase (P/E) cycle number counting method, an electronic device and a computer storage medium. The flash memory includes a plurality of blocks, wherien each block includes a plurality of pages, each page includes a main area and a spare area, a P/E cycle number counting field is defined in a spare area of a target page of each block, and is configured to store a P/E cycle number of each block. In the present application, the P/E cycle number counting field for recording the P/E cycle number is defined in the spare area of the target page of each block based on a basic block operation, and the P/E cycle number be recorded by calling the flash memory driver, without depending on any upper application or file system. For any block, the upper application or the file system may acquire the P/E cycle number of each block by reading the P/E cycle number counting field.

## Description

The present application claims priority to Chinese Patent Application No. 202111276797.4, filed on October 29, 2021, entitled "Flash Memory, Flash Memory Program/Erase Cycle Number Counting Method, Electronic Device and Computer Storage Medium", the entire contents of which are incorporated herein by reference.

### FIELD

The present application relates to the field of the computer technology, and more particularly relates to a flash memory, a flash memory program/erase (P/E) cycle number counting method, an electronic device and a computer storage medium.

### BACKGROUND

Non-volatile memory, such as NAND flash, is configured to store data for a long period of time, and the lifetime of non-volatile memory is usually evaluated by P/E cycle numbers. When the actual P/E cycle number exceed a maximum value, the non-volatile memory is no longer reliable and data stored therein is easily destroyed.

In the related art, P/E cycles of a flash memory are counted by an upper application or a file system. For example, when the upper application or the file system manages blocks of a flash memory through via an UBI (Unsorted Block Image) management system, the UBI management system creates a field in a main area of each block managed by itself for recording the P/E cycle number of the flash memory. However, not all blocks are managed by the UBI management system, which means that the upper application or the file system cannot acquire the P/E cycle numbers of those blocks that are not managed by the UBI management system.

Therefore, how to let the upper application acquire a P/E cycle number of any block is a technical problem that needs to be solved.

### SUMMARY

An objective of the present application is to provide a flash memory, a flash memory P/E cycle number counting method, an electronic device and a computer storage medium, which achieve that an upper application acquires a P/E cycle number of any block.

To achieve the above objective, the present application provides a flash memory, including a plurality of blocks, wherein each block includes a plurality of pages, each page includes a main area and a spare area, a P/E cycle number counting field is defined in a spare area of a target page of each block, and is configured to store a P/E cycle number of each block.

The P/E cycle number counting field includes at least three bytes.

The spare area of the target page is a certain area that contains a bad block information field.

The flash memory includes a Nand-flash memory.

To achieve the above objective, the present application provides a flash memory P/E cycle number counting method, applied to count a P/E cycle number of a target block in the above flash memory, and includes:
determining whether P/E is successful after a P/E action is completed by calling a flash memory driver; and
increasing the value of the P/E cycle number counting field of the target block by one.

The flash memory P/E cycle number counting method further includes:
determining that the target block is a bad block when the P/E fails.

After determining that the target block is the bad block, the flash memory P/E cycle number counting method further incudes:
zeroing a bad block information field of the target block.

The flash memory P/E cycle number counting method further includes:
reading the P/E cycle number counting field of a spare area of a target page of the target block to acquire a current P/E cycle number of the target block.

To achieve the above objective, the present application provides an electronic device, including:
a memory, configured to store a computer program; and
a processor, configured to implement the steps of the above flash memory P/E cycle number counting method when executing the computer program.

To achieve the above objective, the present application provides a computer storage medium storing a computer program, wherein a processor implements the steps of the above flash memory P/E cycle number counting method when the computer program is executed by the processor.

It can be known from the above solution that the flash memory provided by the present application includes the plurality of blocks, wherein each block includes the plurality of pages, each page includes a main area and a spare area, a P/E cycle number counting field is defined in the spare area of the target page of each block, and is configured to store the P/E cycle number of each block. In the present application, the P/E cycle number counting field for recording the P/E cycles is defined in the spare area of the target page of each block based on a basic block operation, and the P/E cycles can be recorded by calling the flash memory driver, without depending on any upper application or file system. For any block, the upper application or the file system can acquire the P/E cycles of each block by reading the P/E cycle number counting field. The present application also discloses the flash memory P/E cycle number counting method, the electronic device and the computer storage medium, which may also achieve the above technical effects.

It should be understood that the above general description and the following detailed description are both exemplary only and cannot limit the present application.

### BRIEF DESCRIPTION OF THE DRAWINGS

To illustrate the technical solutions in the embodiments of the present application or the prior art more clearly, the drawings required to be used in the description of the embodiments or the prior art will be briefly introduced below. Obviously, the drawings in the description below are only some embodiments of the present application, and those of ordinary skill in the art may obtain other drawings according to these drawings, without creative efforts. The drawings are used to further understand the present application and constitute a part of the description, and are used to explain the present application together with the following specific embodiments, but do not constitute limitations of the present application. In the drawings:
FIG. 1 is a structural diagram illustrating a flash memory according to an exemplary embodiment;
FIG. 2 is a flowchart illustrating a flash memory P/E cycle number counting method according to an exemplary embodiment; and
FIG. 3 is a structural diagram illustrating an electronic device according to an exemplary embodiment.

### DETAILED DESCRIPTION

The technical solutions in the embodiments of the present application will be clearly and completely described below in conjunction with the drawings in the embodiments of the present application. Obviously, the described embodiments are only some but not all of the embodiments of the present application. All other embodiments obtained by those of ordinary skill in the art based on the embodiments in the present application without creative efforts fall within the scope of protection of the present application. In addition, "first", "second" and the like in the embodiments of the present application are used for distinguishing between similar objects and not necessarily for describing a particular sequential or chronological order.

An embodiment of the present application discloses a flash memory, including a plurality of blocks, wherein each block includes a plurality of pages, each page includes a main area and a spare area, a P/E cycle number counting field is defined in a spare area of a target page of each block, and is configured to store a P/E cycle number of each block.

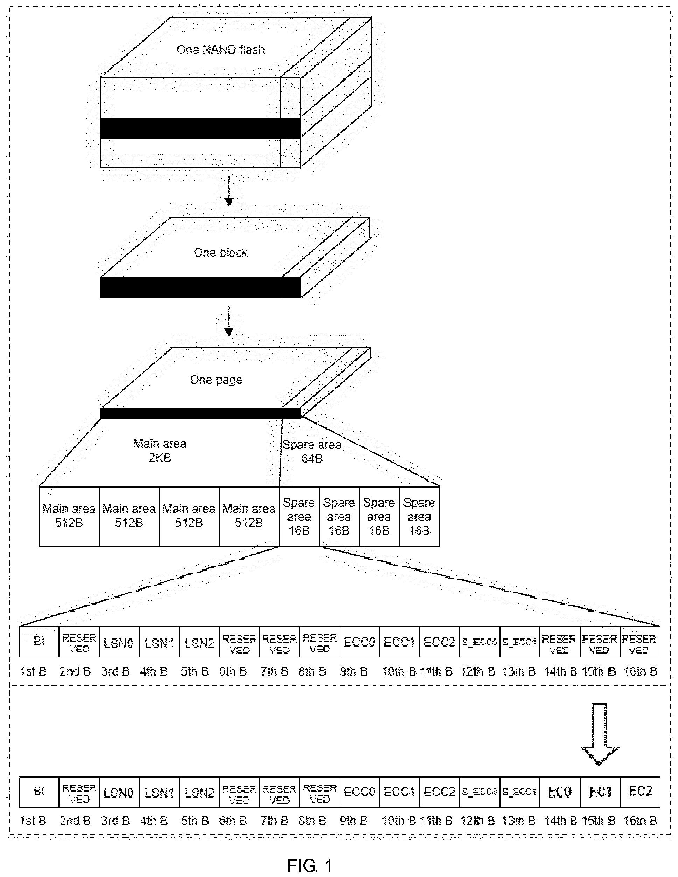

The flash memory in this embodiment may be specifically a Nand-flash memory. Referring to FIG. 1, one flash memory (One NAND Flash) includes a plurality of blocks, each block includes a plurality of pages, and each page includes a main area and a spare area. In FIG. 1, the main area is 2 KB in size, and contains four 512 B sub-areas, and the spare area is 64 B in size, and contains four 16 B sub-areas. One sub-area in the spare area contains 16 bytes. BI (Bad block Information) is a bad block information field. RESERVED is a reserved field. LSN is a logical sector number. ECC is an ECC code for main storage area data. S _ ECC is an ECC code for LSN data.

In this embodiment, a P/E cycle number counting field is defined in a spare area of a target page of each block and is configured to store a P/E cycle number of each block. An upper application or a file system may acquire the P/E cycle number of each block by reading the P/E cycle number counting field of each block. The P/E cycle number counting field not only affects the definition of an existing ONFI (Open NAND Flash Interface), and may also be included in the future definition of the ONFI. Preferably, the spare area of the target page is a certain area that contains a bad block information field. The P/E cycle number counting field at least includes three bytes, for example, in FIG. 1, reserved fields of the 14th byte, the 15th byte and the 16th byte may be set as ECs (Erase Counter).

In the embodiment of the present application, the P/E cycle number counting field for recording the P/E cycle number is defined in the spare area of the target page of each block based on a basic block operation, and the P/E cycle number may be recorded by calling a flash memory driver, without depending on any upper application or file system. For any block, the upper application or the file system may acquire the P/E cycle number of each block by reading the P/E cycle number counting field.

An embodiment of the present application discloses a flash memory P/E cycle number counting method, which achieves that an upper application acquires the P/E cycle number of any block.

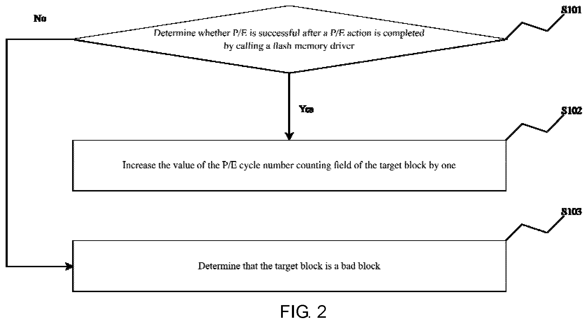

Referring to FIG. 2 which is a flow chart illustrating a flash memory P/E cycle number counting method according to an exemplary embodiment, as shown in FIG. 2, the flash memory P/E cycle number counting method includes:
S101: determining whether P/E is successful after a P/E action is completed by calling a flash memory driver; if so, proceeding to S102; otherwise, proceeding to S103;
S102: increasing the value of the P/E cycle number counting field of a target block by one; and
S103: determining that the target block is a bad block.

This embodiment aims at recording the P/E cycle number of the target block of the flash memory described in the previous embodiment. The flash memory driver in this embodiment has a different function from a flash memory driver in the prior art. The flash memory driver in the prior art is only configured to program and erase a block, and the flash memory driver in this embodiment is configured to record a P/E cycle number of a block in addition to programming and erasing the block. In a specific implementation, an electronic device determines whether P/E is successful immediately after the P/E action is completed by calling the flash memory driver. If so, the value of the P/E cycle number counting field is increased by one, and otherwise, it is determined that the target block is a bad block. Preferably, the bad block information field in the target block is zeroed, i.e., the BI field in FIG. 1 is zeroed, indicating that the target block is a bad block.

The process of the upper application or the file system acquires the P/E cycle number of the target block is as follows: the P/E cycle number counting field is read from the spare area of the target page of the target block to acquire the current P/E cycle number of the target block. In a specific implementation, the upper application or the file system may acquire the current P/E cycle number of the target block by reading the P/E cycle number counting field in the spare area of the target page of the target block, and further decide a load balancing algorithm when data is written, or perform statistics on the use intensity of all the blocks, or infer whether there is a frequent P/E action of the flash memory according to the current P/E cycle number of the target block. It should be noted that the electronic device for recording the P/E cycle number of each block and the electronic device for acquiring the P/E cycle number of each block may be the same electronic device or different electronic devices.

An embodiment of the present application provides a flash memory P/E cycle number counting method. A P/E cycle number counting field for recording a P/E cycle number is defined in a spare area of a target page of each target block based on a basic block operation, and the P/E cycle number may be recorded by calling a flash memory driver, without depending on any upper application or file system. For any block, the upper application or the file system may acquire the P/E cycle number of each block by reading the P/E cycle number counting field.

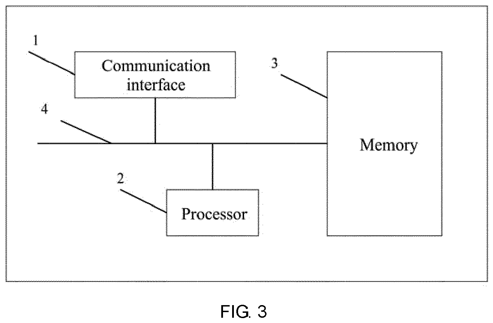

Based on the hardware implementation of the above program module, and in order to implement the method of the embodiment of the present application, an embodiment of the present application further provides an electronic device. FIG. 3 is a structural diagram illustrating an electronic device according to an exemplary embodiment. As shown in FIG. 3, the electronic device includes:
a communication interface 1, which enables an information interaction with other devices such as a network device; and
a processor 2, which is connected with the communication interface 1 to implement information interaction with other devices, and is configured to perform the flash memory P/E cycle number counting method provided by one or more of the above technical solutions when executing the computer program. The computer program is stored on a memory 3.

Of course, various components of the electronic device are coupled together via a bus system 4 during practical application. It will be understood that the bus system 4 is configured to implement connection communication between these components. The bus system 4 includes a power bus, a control bus and a status signal bus in addition to a data bus. However, for clarity of illustration, the various buses are labeled as the bus system 4 in FIG. 3.

The memory 3 in the embodiment of the present application is configured to store various types of data to support the operation of the electronic device. Examples of such data include any computer program for the operation on the electronic device.

It will be understood that the memory 3 may be a volatile memory or a non-volatile memory, or may include both volatile memory and non-volatile memory. The non-volatile memory may be a ROM (Read Only Memory), a PROM (Programmable Read-Only Memory), an EPROM (Erasable Programmable Read-Only Memory), an EEPROM (Electrically Erasable Programmable Read-Only Memory), a FRAM (Ferromagnetic Random Access Memory), a FlashMemory, a magnetic surface memory, an optical disc, or a CD-ROM (Compact Disc Read-Only Memory). The magnetic surface memory may be a magnetic disc memory or a magnetic tape memory. The volatile memory may be a RAM (Random Access Memory), which serves as an external cache. By way of exemplary but not restrictive illustration, many forms of RAM are available, such as SRAM (Static Random Access Memory), SSRAM (Synchronous Static Random Access Memory), DRAM (Dynamic Random Access Memory), SDRAM (Synchronous Dynamic Random Access Memory), DDRSDRAM (Double Data Rate Synchronous Dynamic Random Access Memory), ESDRAM (Enhanced Synchronous Dynamic Random Access Memory), SLDRAM (SyncLink Dynamic Random Access Memory), and DRRAM (Direct Rambus Random Access Memory). The memory 3 described in the embodiment of the present application is intended to include, but is not limited to, these and any other suitable types of memories.

The method disclosed in the above embodiment of the present application may be applied to the processor 2, or is implemented by the processor 2. The processor 2 may be an integrated circuit chip having a signal processing capability. In the implementation processing, the steps of the above method may be implemented by an integrated logic circuit in hardware or by instructions in the form of software in the processor 2. The above processor 2 may be a general-purpose processor, a DSP, or other programmable logic device, a discrete gate or transistor logic device, a discrete hardware component, etc. The processor 2 may implement or execute various methods, steps, and logical blocks disclosed in the embodiments of the present application. The general-purpose processor may be a microprocessor or any conventional processor, etc. The steps of the method disclosed in connection with the embodiments of the present application may be embodied directly as being implemented by a hardware decoder processor, or is implemented by a combination of hardware and software modules in the decoder processor. The software module may be located in a storage medium that is located in the memory 3, and the processor 2 reads the program in the memory 3 to perform the steps of the aforementioned method in conjunction with the hardware.

The corresponding flows in the respective methods of the embodiments of the present application are implemented when the processor 2 executes the program, which will not be described in detail herein for the sake of brevity.

In an exemplary embodiment, an embodiment of the present application further provides a storage medium, which is a computer storage medium, and is specifically a computer-readable storage medium, and for example, includes a memory 3 storing a computer program which may be executed by a processor 2 to complete the steps of the aforementioned method. The computer-readable storage medium may be a memory such as FRAM, ROM, PROM, EPROM, EEPROM, FlashMemory, magnetic surface memory, optical disc, or CD-ROM.

Those of ordinary skill in the art may understand that all or part of the steps of the above method embodiment may be implemented by hardware associated with the program instructions, and the aforementioned program may be stored in the computer-readable storage medium, and the program, when executed, performs the steps including the above method embodiment; and the aforementioned storage medium includes various media that may store program codes, such as a mobile storage device, ROM, RAM, a magnetic disc or an optical disc.

Alternatively, the above integrated unit of the present application, if implemented in the form of a software functional module and sold or used as a stand-alone product, may also be stored in a computer-readable storage medium. Based on such understanding, the technical solutions of the embodiments of the present application essentially or the part contributing to the prior art can be embodied in the form of a software product. The computer software product is stored in a storage medium and includes a plurality of instructions for causing an electronic device (which may be a personal computer, a server, a network device, or the like) to perform all or part of the methods of the various embodiments of the present application. The aforementioned storage medium includes various media storing program codes, such as a mobile storage device, ROM, RAM, a magnetic disc or an optical disc.

The above description is only about the specific embodiments of the present application, but the scope of protection of the present application is not limited thereto. Variations or substitutions can be easily conceived by any person skilled in the art within the technical scope disclosed in the present application, and should be covered by the scope of protection of the present application. Therefore, the scope of protection of the present application should be based on the scope of protection of the claims.

## Claims

1. A flash memory, comprising a plurality of blocks, wherein each block comprises a plurality of pages, each page comprises a main area and a spare area, a P/E cycle number counting field is defined in a spare area of a target page of each block, and is configured to store a P/E cycle number of each block.

2. The flash memory according to claim 1, wherein the P/E cycle number counting field comprises at least three bytes.

3. The flash memory according to claim 1, wherein the spare area of the target page is a certain area that contains a bad block information field.

4. The flash memory according to claim 1, including a Nand-flash memory.

5. A flash memory program/erase (P/E) cycle number counting method, applied to count a P/E cycle number of a target block in the flash memory according to any one of claims 1-4, and comprising:
determining whether P/E is successful after a P/E action is completed by calling a flash memory driver; and
increasing the value of the P/E cycle number counting field of the target block by one.

6. The flash memory P/E cycle number counting method according to claim 5, further comprising: determining that the target block is a bad block when the P/E fails.

7. The flash memory P/E cycle number counting method according to claim 6, further comprising: after determining that the target block is the bad block,
zeroing a bad block information field of the target block.

8. The flash memory P/E cycle number counting method according to claim 5, further comprising:
reading the P/E cycle number counting field of a spare area of a target page of the target block to acquire a current P/E cycle number of the target block.

9. An electronic device, comprising:
a memory, configured to store a computer program; and
a processor, configured to implement the steps of the flash memory P/E cycle number counting method according to any one of claims 5-8 when executing the computer program.

10. A computer storage medium, storing a computer program, wherein a processor implements the steps of the flash memory P/E cycle number counting method according to any one of claims 5 to 8 when the computer program is executed by the processor.
